# EUROPEAN PATENT APPLICATION

(11) **EP 1 615 262 A1**
(43) Date of publication of application: **11.01.2006**
(21) Application number: 04300439.9
(22) Date of filing: 09.07.2004
(51) Int. Cl.: H01L 21/336, H01L 27/12, H01L 29/786

(54) **Active matrix for oled display**

(71) Applicant: Thomson Licensing, 92100 Boulogne Billancourt (FR)
(72) Inventor: Prat, Christophe, 44000, NANTES (FR); Gaillard, Arc'hanmael c/o Thomson, 92648 Boulogne Billancourt (FR); Mohammed-Brahim, Tayeb, THOMSON, 92648 Boulogne Billancourt (FR); Crand, Samuel, Thomson, 92648 Boulogne Billancourt (FR); Le Roy, Philippe, Thomson, 92648 Boulogne Billancourt (FR); Rogel, Regis c/o Thomson, 92648 Boulogne Billancourt (FR)
(74) Representative: Ruellan-Lemonnier, Brigitte

(57) **Abstract**

Active matrix comprising a crystallized silicon layer (12, 13) on a base plate (10, 11) embedding pixel circuits, each of which comprises at least one top-gate or coplanar transistor (T1, T2) having a drain electrode (18), a source electrode, and a gate electrode (21), with a channel (14) between the drain and the source, with a silicon oxide layer (17) inserted between the gate electrode (21) and the channel (14). Within the silicon layer (12, 13), the average hydrogen atomic concentration is ≤ 3%, and the mean size of silicon crystals is between 10 nm and 100 nm.

All transistors have very homogeneous and stable electrical properties. OLED displays based on such an active matrix have very homogeneous and stable luminance even with very simple and cheap pixel circuits.

## Description

The invention relates to an improved active matrix and its manufacturing process that allows, even for large area matrix, higher reliability and uniformity of electrical characteristics of field effect thin film transistors (TFT) that are integrated or embedded into such an active matrix. Such an active matrix can be advantageously used for the addressing and power supply of active-matrix organic light-emitting diode (AMOLED) displays or active-matrix polymer light-emitting diode (AMPLED) displays, even with very simple and cheap 2-TFT conventional pixel circuits to drive and power each diode.

Driving displays, particularly displays based on electroluminescent devices, need well controlled and reliable electrical signals. Current levels according to wanted luminance are controlled by thin film transistors in each light-emitting diode of the display. Various silicon materials are used to build these transistors.

Hydrogenated amorphous silicon TFT is a mature technology but suffers to time degradation and instability of electrical characteristics, due to the behaviour of hydrogen in the material.

Amorphous silicon crystallization results in polycrystalline material that has a higher electrical quality. Laser crystallization of amorphous silicon induces large grain size and high field-effect mobility that is needed for high-speed applications. However, due to the high surface roughness and the need of scanning of a Laser beam to crystallize large areas, TFT matrix made from this crystallized material suffers electrical parameters deviation. Consequently, various electronic circuits using numerous TFTs for each light-emitting diode, associated with compensation techniques, have been proposed to overcome this problem.

The parameters of TFTs made from Solid-Phase Crystallized (SPC) silicon are more uniform even if the electrical quality is not so high. However, a major drawback is that the crystallization step takes several hours.

The object of the invention is to avoid the aforementioned drawbacks, by proposing another way to get a silicon layer for active matrix, by using a deposition of silicon directly in the polycrystalline state (so-called "as-deposited silicon"). As a small grain size of silicon is obtained, the electrical characteristics of the TFT that may be integrated or embedded in the layer are not very high but the uniformity and the stability of these characteristics is highly improved on the whole layer, allowing the use of simple 2-TFT conventional pixel circuits to control each light-emitting diode of a display, without adding any specific compensation means, and even for large displays.

For this purpose, the subject of the invention is an active matrix comprising a crystallized silicon layer and a base plate on which this layer is deposited, intended to be used as a substrate for electro-optical elements of a display, said layer including, for each of said elements, a control and power supply circuit, that comprises at least one transistor having a drain electrode, a source electrode, and a gate electrode, with a channel between the drain electrode and the source electrode, with insulating material inserted between said gate electrode and the silicon surface of said channel, characterized in that :
- within said silicon layer :
   ο the average hydrogen atomic concentration is inferior or equal to 3%;
   o the mean size of silicon crystals is superior or equal to 10 nm and inferior or equal to 100 nm;
- said insulating material comprises a layer of silicon oxide at the interface with said silicon layer;
- said transistors are top-gate transistors or coplanar-electrodes transistors.

Thanks to hydrogen-free and small grained silicon layers, to silicon oxide oxide as insulating material between the gate electrode and the silicon surface of the channel of each transistor of the active matrix, to the top-gate or coplanar structure of the transistors, electrical characteristics of all these transistors are highly uniform and stable. Without departing from the invention, each transistor may comprise other layers that overlay the silicon oxide layer and that may be made of insulating materials that are different from silicon oxide.

Preferably, the material that is located, in each transistor, between the silicon layer and the silicon oxide layer is passivated.

Preferably, said silicon layer is basically textured {110}. Preferably, within the silicon layer, the average hydrogen atomic concentration is inferior or equal to 1%, and/or the mean size of silicon crystals is inferior or equal to 50 nm.

Preferably, for each transistor, the channel comprises more than 50 silicon crystals.

Preferably, each said control and power supply circuit comprises at most two transistors.

The subject of the invention is also a display panel comprising a substrate and a bi-dimensionnal network of electro-optical elements that are deposited on said substrate, characterized in that said substrate is an active matrix according to the invention.

Preferably, said electro-optical elements are organic or polymer light emitting diodes.

Preferably, each control and power supply circuit comprises one transistor to control the current within the light emitting diode to which it is connected through its drain or source electrode, said transistor having a channel that comprises more than 50 silicon crystals. Thanks to this high number of grains within the channel of each current control transistor brings to these transistors electrical properties that are homogeneous and stable enough to get a very homogeneous and stable luminance over the whole display. Fig. 8 shows that the lower is the grain size GS of silicon within the silicon layer in which transistors are embedded, the lower is the current variation in saturation ΔI_{SAT} of these transistors, i.e. the more homogeneous are the electrical properties of these transistors.

The subject of the invention is also a method of making an active matrix according to the invention comprising at least one deposition step of a silicon layer on a base plate, followed by an etching step to form a channel within said silicon layer for each transistor, followed by a deposition step of an insulating silicon oxide layer, characterized in that it comprises no hydrogenation step and and no recrystallization step, as, for instance, a recrystallization with a laser beam.

Whithout departing from the invention, other layers of insulating material can be deposited on this silicon oxide layer, as soon as the first insulating material that is deposited on silicon is a silicon oxide layer.

Preferably, between the said etching step and the said deposition step of an insulating layer, a surface passivation step of the silicon surface of the channels that have been etched is included. Preferably, said passivation is obtained by an oxygen plasma treatment.

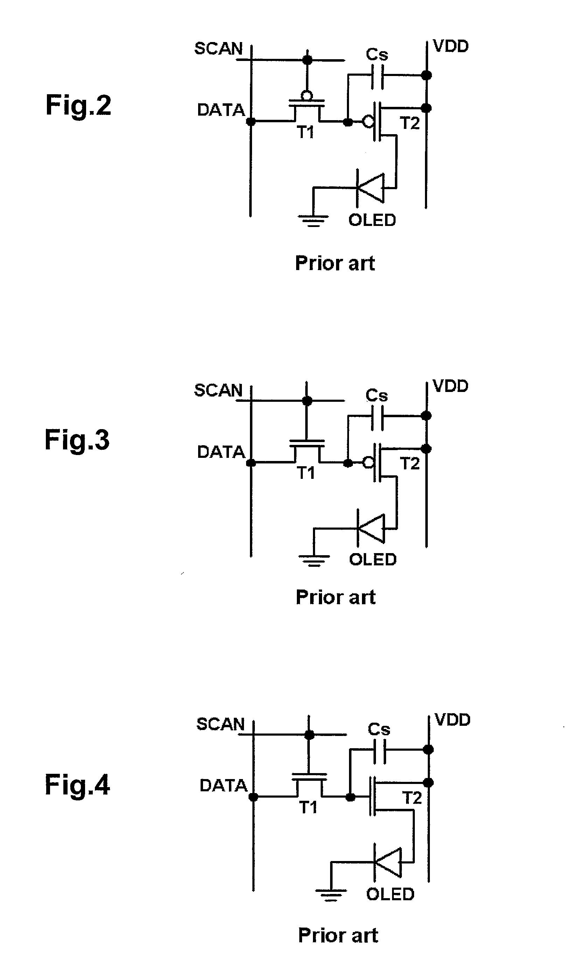

As threshold voltage Vₜₕ and subthreshold slope S of the transistors, and mobility µ of carriers inside silicon, are partly determined by the defect density in the channel and at the insulator channel interface of these transistors, thanks to the passivation of these defects, electrical characteristics of all the transistors of the active matrix are still more uniform and still more stable. Threshold voltage variations and current shift in saturation region are strongly reduced. Similar low variations and shift are obtained using the usual simple 2-TFTs pixel circuit (see fig.2 to 4) or a more complex and costly 4-TFTs pixel circuit including a compensating cell as disclosed by S.H. Jung, W.J. Nam, M.K. Han in an article entitled "A New Voltage Modulated AMOLED Pixel Design Compensating Threshold Voltage Variation of Poly-Si TFTs.", SID 2002, pp 622.

The invention will be more clearly understood on reading the description which follows, given by way of non-limiting example and with reference to the appended figures in which:

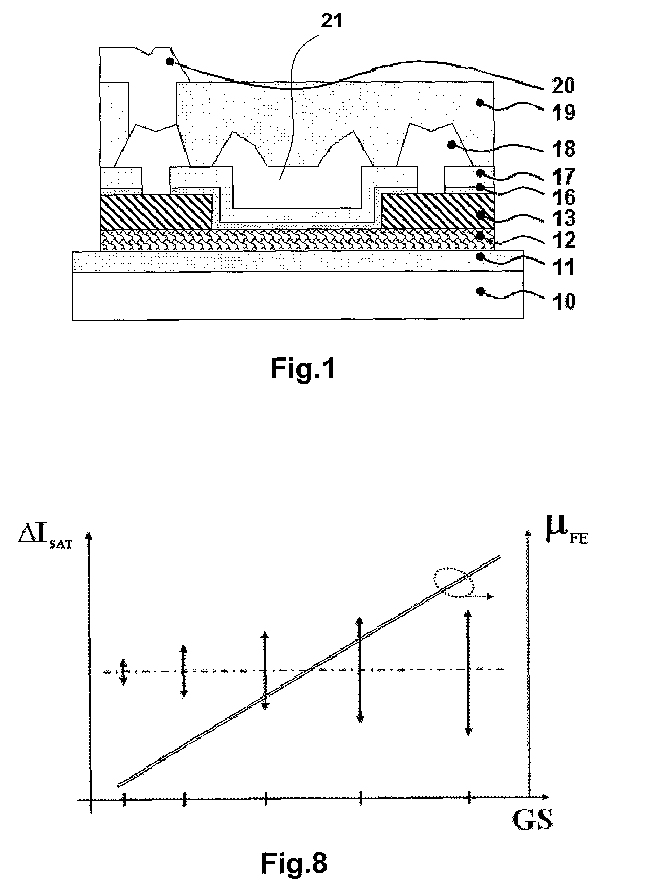

- Figure 1 is a cross-sectional view of a thin film transistor related to an active matrix according to one embodiment of the invention ;
- Fig. 2-4 are schematic views of conventional pixel circuits according to prior art, that may be advantageously embedded in an active matrix of the invention ;
- Fig. 5 to 7 are cross-sectional views at different manufacturing steps of the thin film transistor of fig.1, according to a manufacturing embodiment of the invention;
- Fig. 8 is a graph chart showing a relation between current variation in saturation ΔI_{SAT} of TFT transistors and field effect mobility µ_{FE} according to polysilicon grain size GS within silicon layer in which these transistors are embedded, such transistors and silicon layer belonging to active matrix according to different embodiments of the invention.

A process to manufacture an active matrix according to one embodiment of the invention will now be described. This active matrix is intended to be used as a substrate for a network of top emitting organic light emitting diodes, that will form a video display panel.

Behind each OLED, a control and power supply circuit, or so-called "pixel circuit"; is needed, which comprises a current modulator T2 and a scanning switch T1 that are both thin film transistors, and a capacitor Cs, that are all embedded within the active matrix, and that are connected together as disclosed in either fig. 2, 3 or 4.

Two column-electrodes networks and one row-electrodes network are also embedded within the active matrix (not shown), with one electrode of each of the three networks connected to one of the three terminals of each pixel circuit, to supply a supply voltage VDD to a 1st terminal (drain or source) of T2, to deliver a DATA voltage to a 1^{st} terminal (drain or source) of T1, and to deliver a scanning signal SCAN to the gate terminal of T1. The other 2^{nd} terminal (drain or source) of T2 is intended to be connected with one electrode of the corresponding OLED. The other 2^{nd} terminal (drain or source) of T1 is connected with the gate terminal of T2 . In each pixel circuit, the capacitor Cs is connected between the gate terminal of T2 and with the said 1^{st} terminal of T2.

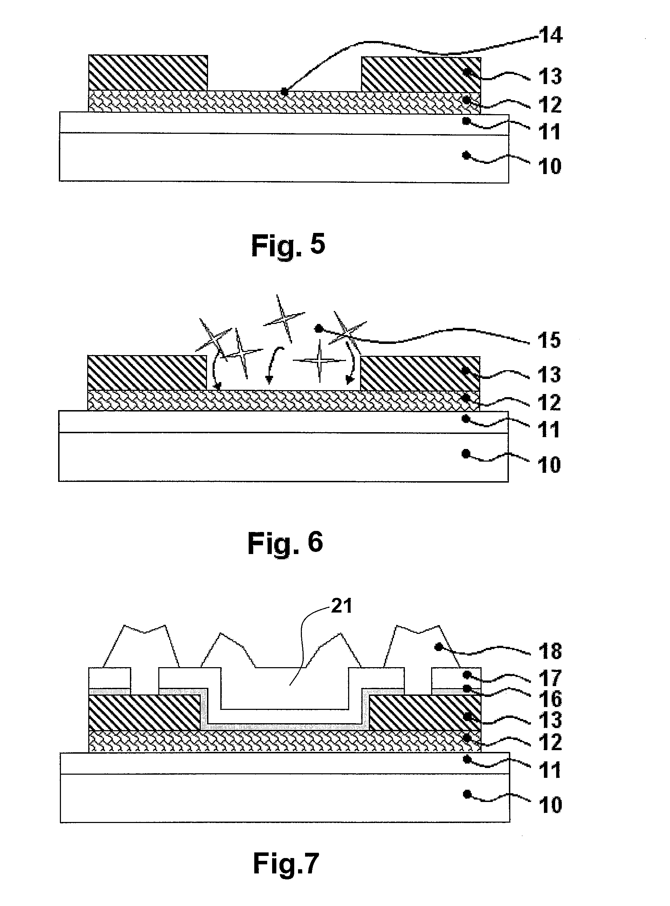

The process to manufacture this active matrix is illustrated by Fig. 5 through Fig. 7. This active matrix is manufactured on a base plate which is made of two layers 10, 11. At least the top layer 11 is made of insulating material, that is preferably selected from the group consisting of glass, quartz, silicon dioxide ; other insulating material may be used.

A first poly(micro)-crystalline silicon layer 12 is then deposited on the base plate 10, 11. This layer 12 can be deposited during a 1^{st} step by different chemical vapour deposition (CVD) techniques as low pressure CVD (LPCVD) technique for example. LPCVD techniques are well known in the art and are for example disclosed or referenced in the following publications :
- M. Miyasaka, T. Nakazawa, W. Itoh, I. Yudasaka, H. Ohshima, "Transistor and physical properties of polycrystalline silicon films prepared by infralow-pressure chemical vapor deposition", J. Appl. Phys. vol. 74 (1993) pp. 2870-2885.
- M. Modreanu, N. Tomozeiu, M. Gartner, P. Cosmin, "Microstructural and optical properties of as-deposited LPCVD silicon films", Thin Solid Films 383 (2001) pp254-257.

A second doped silicon thin film 13 is then deposited during a 2^{nd} step in continuity with the 1^{st} step (no deposition interruption). Deposition conditions (pressure, temperature, ...) are chosen as known by man skilled in the art to be compatible with the base plate 10, 11 and to obtain as-deposited poly(micro)-crystalline silicon with {110} oriented grains. The obtained mean grain size is small (- 50 nm). Consequently a large number of grains are present within the channel of any transistor that will be later embedded within the silicon layers 12, 13. Both the small grain size and the same grain orientation favour a significant contribution to the uniformity of electrical characteristics of these transistors. Silicon grains that are oriented {110} means that the surface of the silicon layer is basically textured {110}. Such a texture can be controled by standard X-ray diffraction measurements. By extension, it is considered that the silicon layer itself is basically textured {110}.

Conventional photolithography techniques (photoresist, mask,...) are now used (not shown) to produce a patterned mask as depicted in Fig. 5 for one transistor. Plasma etching like reactive ion etching (RIE) or wet etching is used to etch the polysilicon layers 12, 13 to form the drain and source regions separated by a channel 14 for each transistor of the active matrix, as well as to insulate the different electrodes of each of these transistors. Then, as shown in Fig. 6, an oxygen plasma 15 treatment of the channel surface of the transistors is then introduced to improve the process before the deposition of the silicon dioxide gate insulator layer 17. The oxygen plasma treatment is supposed to form a thin passivation layer 16 that passivates the defects that are located at the surface of the channels 14 and also to highly improve the uniformity of the surface of the silicon layer 12 on the whole active matrix. Low temperature deposited silicon dioxide is then used to form a gate insulator layer 17 to get transistors having therefore a top-gate structure. The gate insulator layer 17 may be entirely made of silicon dioxide, or may be a multi-layer comprising a stack of silicon dioxide sublayer(s) with sublayer(s) made of other compatible insulating material. Conventional processing methods may then be used to form terminals 18; 21 on each electrodes (drain, source, or gate 21) of the transistors, and to form wirings, as drain or source wiring 20, to connect these terminals either to lines and columns electrodes of the active matrix, either to one electrode of an OLED to be deposited later on. An insulating layer 19 is added for insulation purposes. As can be seen on figure 7, for these top-gate transistors, the average level of their drain electrode and of their source electrode is positioned between the base plate 10, 11 and the average level of their gate electrode 21. According to a variant, a coplanar-electrodes structure may be used for the transistors, where all the electrodes of any transistor are positioned at the same average level.

Known conventional methods are used to deposit the electrodes networks, but these will not be described here.

Other passivation layer(s) (not shown) may be needed for electrical insulating purposes.

The active matrix according to the invention is thus obtained.

As silicon is directly deposited on the base plate in the polycrystalline state, process steps reduction is advantageously obtained in comparison in processes that are disclosed in prior, as those comprising amorphous silicon deposition and subsequent recrystallization by a laser beam.

As no hydrogenation step is introduced in the process as described above, silicon layers of the active matrix are hydrogen-free, i.e. the average hydrogen atomic concentration within these silicon layers 12, 13 is inferior or equal to 1%.

As the mean size of the silicon crystals is small, the silicon surface of the channel 14 of any transistor, at the interface with the insulating layer 17, comprises a large number of silicon crystals, that are of course embedded within the silicon layer 12. As demonstrated by experimental results (not disclosed in detail this document), a number of grains higher than 50 within the channel of each transistor of the active matrix, mainly the transistors T2 which are intended to control the current within electro-optical elements that are deposited on the active matrix, brings to these transistors electrical properties that are homogeneous and stable enough to get an homogeneous and stable luminance over the whole display.

With such hydrogen-free and small grained silicon layers, when using silicon oxide as insulating material between electrodes of each transistor of the active matrix, if building transistors with top-gate structure, then electrical characteristics of all these transistors are highly uniform and stable.

Then, to get an OLED display according to one embodiment of the invention, organic light emitting diodes are deposited on each pixel circuit of the active matrix, using known conventional methods that will not be described here; one electrode of each OLED is connected to the 2^{nd} terminal of T2 of each pixel circuit. A common transparent electrode is then deposited on the OLED layer, to which other electrode of each OLED is connected (generally ground electrode). Then an encapsulation layer is deposited to avoid any degradation of the organic layers of the OLEDs.

An OLED display according to the invention is thus obtained.

Although there is only 2 TFT within each pixel circuit in this display with no compensating means (as to compensate threshold voltage differences and/or drift), a homogeneous luminance can be obtained easily on the whole display, even for large size display over 30 cm diagonal. No degradation of this homogeneity has been observed after hours of image display.

It has been noticed that the passivation of the defects that are located at the surface of the channels that are etched within the silicon layer of the active matrix, using for instance oxygen plasma treatment as disclosed above, still improve the homogeneity and the stability of the luminance of the display.

Other processes than the above disclosed process can be used to get an active matrix and/or an OLED display without departing from the invention.

Active matrix according to the invention can be advantageously used as a substrate for other kind of display, like for LCD displays for example.

## Claims

1. Active matrix comprising a crystallized silicon layer (12, 13) and a base plate (10, 11) on which this layer is deposited, intended to be used as a substrate for electro-optical elements of a display, said layer including, for each of said elements, a control and power supply circuit, that comprises at least one transistor (T1, T2) having a drain electrode (18), a source electrode, and a gate electrode (21), with a channel (14) between the drain electrode and the source electrode, with insulating material inserted between said gate electrode (21) and the silicon surface of said channel (14), **characterized in that** :
- within said silicon layer (12, 13)
o the average hydrogen atomic concentration is inferior or equal to 3%;
o the mean size of silicon crystals is superior or equal to 10 nm and inferior or equal to 100 nm;
- said insulating material comprises a layer of silicon oxide (17) at the interface with said silicon layer;
- said transistors are top-gate transistors or coplanar-electrodes transistors.

2. Active matrix according to claim 1, **characterized in that**, within said silicon layer, the average hydrogen atomic concentration is inferior or equal to 1%.

3. Active matrix according to claim 1 or 2, **characterized in that**, within said silicon layer, the mean size of silicon crystals is inferior or equal to 50 nm.

4. Active matrix according to any of claims 1 to 3, **characterized in that**, for each of said transistors, said channel (14) comprises more than 50 silicon crystals.

5. Active matrix according to any of claims 1 to 4, **characterized in that**, each said control and power supply circuit comprises at most two transistors.

6. Display panel comprising a substrate and a bi-dimensionnal network of electro-optical elements that are deposited on said substrate, **characterized in that** said substrate is an active matrix according to any of the preceding claims.

7. Display panel according to claim 6, **characterized in that** said electro-optical elements are organic or polymer light emitting diodes.

8. Display panel according to claim 7, **characterized in that** each control and power supply circuit comprises one transistor (T2) to control the current within the light emitting diode to which it is connected through its drain or source electrode (18), said transistor having a channel (14) that comprises more than 50 silicon crystals.

9. Method of making an active matrix according to any of claims 1 to 5 comprising at least one deposition step of a silicon layer (12, 13) on a base plate (10, 11), followed by an etching step to form a channel (14) within said silicon layer (13) for each transistor, followed by a deposition step of an insulating silicon oxide layer (17), **characterized in that** it comprises no hydrogenation step and no recrystallization step.

10. Method according to claim 9 **characterized in that** it comprises, between the said etching step and the said deposition step of an insulating layer, a surface passivation step of the silicon surface of the channels (14) that have been etched.

11. Method according to claim 10 **characterized in that** said passivation is obtained by an oxygen plasma treatment.
